# EUROPÄISCHE PATENTANMELDUNG

(11) **EP 0 989 598 A2**
(43) Veröffentlichungstag der Anmeldung: **29.03.2000**
(21) Anmeldenummer: 99117981.3
(22) Anmeldetag: 15.09.1999
(51) Int. Cl.: H01L 21/311, H01L 21/033, H01L 21/027

(54) **Verfahren zur Nassätzung einer Halbleiterstruktur**

(30) Priorität: 25.09.1998 DE 19844102
(71) Anmelder: SIEMENS AKTIENGESELLSCHAFT, 80333 München (DE)
(72) Erfinder: Claussen, Wilhelm, Dr., 01129 Dresden (DE); Vogt, Mirko, Dr., 01217 Dresden (DE); Lorenz, Barbara, 01109 Dresden (DE); Sperlich, Hans-Peter, 01309 Dresden (DE); Penner, Klaus, 01458 Ottendorf-Okrilla (DE)

(57) **Zusammenfassung**

Auf eine aus dotierten Siliziumoxid bestehende Hartmaskenschicht (4) wird ohne Unterbrechung des Vakuums eine insbesondere dielektrische Antireflexschicht (5) mittels PECVD aufgebracht. Dann wird die Siliziumoxidschicht zur Hartmaske strukturiert und beispielsweise die Deep-Trench-Ätzung ausgeführt. Die Hartmaske (4) wird in einem HF/H₂SO₄-Gemisch oder in einem HF/Ethylenglycol-Gemisch mit hoher Ätzrate entfernt. Bei Verwendung eines HF/EG-Gemisches kann gleichzeitig eine ggf. darunter angeordnete Zwischenschicht (2, 3) um ein vorgegebenes Maß zurückgeätzt werden. Diese Integration zweier Naßätzschritte stellt eine große Vereinfachung gegenüber den bisherigen Naßätzverfahren in zwei verschiedenen Anlagen dar.

## Beschreibung

Die Erfindung betrifft ein Herstellverfahren für eine Halbleiterstruktur in einer integrierten Schaltung, insbesondere ein Verfahren zur Herstellung einer Hartmaske und ein Verfahren zur Entfernung der Hartmaske.

In Halbleitertechnologie zählen Siliziumoxide zu den am häufigsten verwendeten Materialien. Es sind verschiedene Arten von Siliziumoxiden (Gläsern) bekannt, die sich in ihrer Zusammensetzung, ihren Eigenschaften und ihrer Herstellung unterscheiden, beispielsweise thermische und abgeschiedene Oxide, TEOS, dotierte Oxide. In vielen Fällen werden sie als Isolationsmaterial verwendet. Eine weitere wichtige Anwendung ist ihr Einsatz als Hartmaske während der Ätzung tieferliegender Schichten. Eine derartige Hartmaske wird nach dem Ätzprozeß wieder entfernt.

Zur Erzeugung der Hartmaske ist ein fotolithografischer Prozeß notwendig. Um dabei Strukturübertragungsfehler zu verringern, kann eine Antireflexschicht (ARC) auf die Hartmaskenschicht aufgebracht werden, wozu üblicherweise ein plasmagestützter Abscheideprozeß eingesetzt wird. Gängige Verfahren sehen vor, die aus einem Siliziumoxid bestehende Hartmaskenschicht in der Vakuumkammer einer ersten Anlage aufzubringen und dann die Antireflexschicht in einer zweiten Anlage aufzubringen.

Nach dem Strukturierungsprozeß soll die Hartmaske aus Siliziumoxid bestehende möglichst schnell und meist selektiv zu anderen vorhandenen Schichten (z.B. thermisches Siliziumoxid, Siliziumnitrid) naßchemisch entfernt werden. Dies erfordert eine hohe und zahlenmäßig genau bekannte Ätzrate der Hartmaske. Durch die Einwirkung des plasmagestützten Abscheideprozesses für die Antireflexschicht auf die exponierte Siliziumoxidschicht wird jedoch deren Ätzrate in unkontrollierter Weise verringert. Die Änderung der Ätzrate ist auf chemische und physikalische Schichtmodifikationen durch die nachfolgende Plasma-Abscheidung zurückzuführen. Da die Ätzrate der Hartmaskenschicht nicht ausreichend kontrollierbar ist, wird unter Fertigungs-bedingungen die Hartmaske nicht mit einer feststehenden Prozeßzeit entfernt, sondern es wird für eine gewisse Anzahl von Wafern (d.h. eine Charge) die Prozeßzeit in einem separaten Vorläufertest bestimmt. Für jede Charge wird in dieser Weise eine individuelle Ätzzeit festgelegt. Nur diese zeitaufwendige und kostenintensive Vorgehensweise kann ein zu hoher Abtrag von anderen auf dem Wafer vorhandenen Schichten vermieden werden.

Ein Beispiel für den Einsatz einer Hartmaske aus dotiertem Siliziumoxid mit überliegender Antireflexschicht ist die Ätzung von Kondensatorgräben in einem Siliziumsubstrat, insbesondere für ein Ein-Transistor-Speicherzellen. Bei diesem Ätzprozeß ist direkt auf der Substratoberfläche in der Regel eine Zwischenschicht bestehend aus thermischem Siliziumoxid und/oder Siliziumnitrid angeordnet, die bei der Entfernung der Hartmaske nach der Grabenätzung nicht oder nur geringfügig angegriffen werden darf. Es kann günstig sein, diese Zwischenschicht um ein definiertes Maß horizontal zurückzuätzen (sog. Pull-Back), z.B um eine bessere Auffüllbarkeit des Grabens zu ermöglichen. Nach einem bekannten Verfahren werden hierbei zur Entfernung der Siliziumoxid-basierten Hartmaskenschichten Gemische aus H₂SO₄/HF bei etwa 60°C auf einem Spinetcher verwendet. Die Selektivität des Abtrages einer dotierten Glasschicht mit 4 Gew.% Bor zum Abtrag einer ebenfalls auf dem Wafer liegenden thermischen Siliziumoxidschicht beträgt dabei etwa 35:1. Um einen unzulässig hohen Abtrag des thermischen Oxides zu verhindern, wird aus jedem Los ein Wafer separat einem vorgelagerten Prozeßschritt zur Bestimmung der Ätzrate unterzogen. Anschließend wird das gesamte Los mit der sich aus der so ermittelten Ätzrate ergebenden Ätzzeit prozessiert. Dieser dem eigentlichen Ätzprozeß vorgelagerte Schritt verringert den Waferdurchsatz erheblich. Nach der Entfernung der Hartmaske werden in einem weiteren Prozeßschritt die Kanten der unter der Hartmaske befindlichen Siliziumnitridschicht mit einer isotropen Ätzung in einem HF/Ethylenglycol-Gemisch in einer anderen Ätzanlage zurückgeätzt.

Es ist bekannt, die Naßätzrate dotierter Siliziumoxid-Hartmasken durch Erhöhung der Dotierstoffkonzentration der Schichten zu erhöhen. Dies vermindert jedoch deren Schichtstabilität im Ätzprozeß, d.h. die Schichten erfüllen nicht mehr die für ihren Einsatz als Maske relevanten Anforderungen.

Der Erfindung liegt das Problem zugrunde, ein Verfahren zur Herstellung einer aus Siliziumoxid bestehenden stabilen Hartmaske und einer darüber liegenden Antireflexschicht anzugeben, sowie ein Ätzverfahren anzugeben, mit dem die Siliziumoxid-Hartmaske mit hoher Ätzrate entfernt werden kann. Dieses Ätzverfahren soll eine hohe und ggf. eine definiert einstellbare Selektivität zu anderen Schichten, insbesondere zu einer Zwischenschicht aus thermischem Siliziumoxid und/oder Siliziumnitrid aufweisen.

Diese Aufgabe wird durch ein Verfahren mit den Merkmalen des Patentanspruchs 1 gelöst.

Das erfindungsgemäße Verfahren beruht zum einen darauf, eine aus einem dotiertem Siliziumoxid bestehende Hartmaskenschicht und eine Antireflexschicht aufeinanderfolgend ohne Unterbrechung der Vakuum-Bedingungen für den Wafer mittels plasmagestützter Abscheideprozesse aufzubringen. Die Erfindung beruht zum anderen darauf, für die Entfernung der Hartmaske ein Gemisch aus HF und Ethylenglycol (EG) und/oder Schwefelsäure einzusetzten, das für die so hergestellte Hartmaske sowohl eine hohe Ätzrate aufweist als auch eine hohe und definierte Selektivität zu eventuell vorhandenen weiteren Schichten auf dem Substrat.

Durch das "In-Situ"-Aufbringen der Antireflexschicht auf die Siliziumoxidschicht wird die direkte Einwirkung der Umgebungsatmosphäre auf die Siliziumoxidschicht vermindert und die Feuchteaufnahme deutlich verringert. Dies resultiert in einer höheren Ätzrate für die Siliziumoxidschicht.

Gleichzeitig wird bei der Herstellung der Antireflexschicht eine höhere Abscheiderate erzielt, so daß die Abscheidung in kürzerer Zeit erfolgen kann und die Plasmaexposition der Hartmaskenschicht verringert wird. Dies bewirkt eine geringere Modifikation der Schichteigenschaften und eine höhere Ätzrate für die Hartmaske.

Als Hartmaskenschicht wird vorzugsweise ein dotiertes Glas mit 2 bis 9 Gew.% B und/oder 2 bis 9 Gew.% P verwendet. Dabei wird eine Borkonzentration von 3,5 bis 4 % ohne Zusatz von Phosphor besonders bevorzugt, da eine solche dotierte Glasschicht (BSG) besonders gute Hartmaskeneigenschaften besitzt. Für die Herstellung der Schicht kann ein üblicher ozongestützter SA (sub-atmosphere-) CVD-Prozeß eingesetzt werden. Insbesondere wenn eine hochdotierte Schicht (≥ 4 Gew.% B) verwendet wird, kann vor der Abscheidung der Antireflexschicht ein Inertplasmaschritt durchgeführt werden, der dem Verfestigen der BSG-Schicht dient und in dem keine Schichtabscheidung erfolgt. Dieser Inertplasmaschritt kann durch Veränderung der Plasmaleistung und der Prozeßzeit den speziellen Anforderungen dahingehend angepaßt werden, daß die Forderungen sowohl nach ausreichender Hartmaskenstabilität als auch nach hoher BSG-Naßätzrate erfüllt werden können. Als Prozeßgase werden dabei ein Inertgas, beispiels-weise Argon, Helium oder Stickstoff, ggf. auch N₂O, zugeführt. Als Antireflexschicht wird vorzugsweise ein Dielektrikum, z.B. ein Oxynitrid (SiOxNy) verwendet.

Für die Ätzung der so hergestellten Glasschicht kann eine Naßätzung mit einem HF-H₂SO₄-Gemisch eingesetzt werden. Mit dem neuen Abscheideprozeß wird dabei eine Ätzrate von etwa 2000-3000 nm/min erreicht (gegenüber etwa 600 nm/min bei dem bisherigen Verfahren), die Selektivität zu thermischem Oxid bzw. Nitrid wird entsprechend vergrößert. Durch das neue integrierte Abscheideverfahren der Hartmaske und der Antireflexschicht werden also mit dem bisherigen Naßätzprozeß eine stark erhöhte Ätzrate und Selektivität erzielt. Es kann bspw. ein HF/H₂SO₄-Gemisch im Mischungsverhältnis 1/7 bei einer Prozeßtemperatur von etwa 60°C verwendet werden.

Ferner kann eine Naßätzung mit einem HF-EG-Gemisch eingesetzt werden, das vorzugsweise 2 bis 10 Vol.% HF und 98 bis 90 Vol.% EG aufweist. Es wird eine Naßätzrate für dotierte Oxide von 200 bis 1.600 nm/min erzielt. Die Selektivität zu thermischen Siliziumoxid oder Siliziumnitrid liegt im Bereich 70 bis 550:1.

Durch die hohe Selektivität ist mit beiden Ätzprozessen im oben erläuterten Anwendungsbeispiel eine Entfernung der Hartmaske mit fester Prozeßzeit (ohne Vorläufertest) möglich. Durch den Wegfall der aufwendigen Bestimmung der Ätzzeit für jede Charge wird die Bearbeitungszeit wesentlich reduziert. Ferner wird eine kürzere Ätzzeit benötigt. Insgesamt wird die Bearbeitungszeit auf etwa 40-50% gegenüber dem konventionellen Verfahren reduziert.

Besonders vorteilhaft ist das Verfahren mit einer HF-EG-Ätzlösung bei dem oben angegebenen Beispiel anwendbar, bei dem die Hartmaske auf einer Zwischenschicht aus thermischem Oxid und Nitrid aufgebracht wird und nach der Entfernung der Hartmaske ein Pull-Back der Zwischenschicht durchgeführt werden soll. Bei dem bekannten Verfahren sind dazu zwei verschiedene Ätzverfahren notwendig. Das erfindungsgemäße Verfahren bietet den Vorteil, daß beide Ätzschritte in einen Ätzschritt integriert werden können, da eine ausreichend hohe und einstellbare Selektivität zwischen der Ätzung der Hartmaske und der Zwischenschicht vorliegt.

Wird beim angegebenen Beispiel eine Konventionelle HF-H₂SO₄-Ätzung durchgeführt, wird ebenfalls eine beträchtliche Zeiteinsparung erzielt. Allerdings ist die Selektivität zur Zwischenschicht so hoch, daß der Pull-Back in einem speraten Schritt mit HF-EG erfolgen muß.

Die Erfindung wird im folgenden anhand eines Ausführungsbeispiels und der Zeichnungen naher erläutert.
Es zeigen:

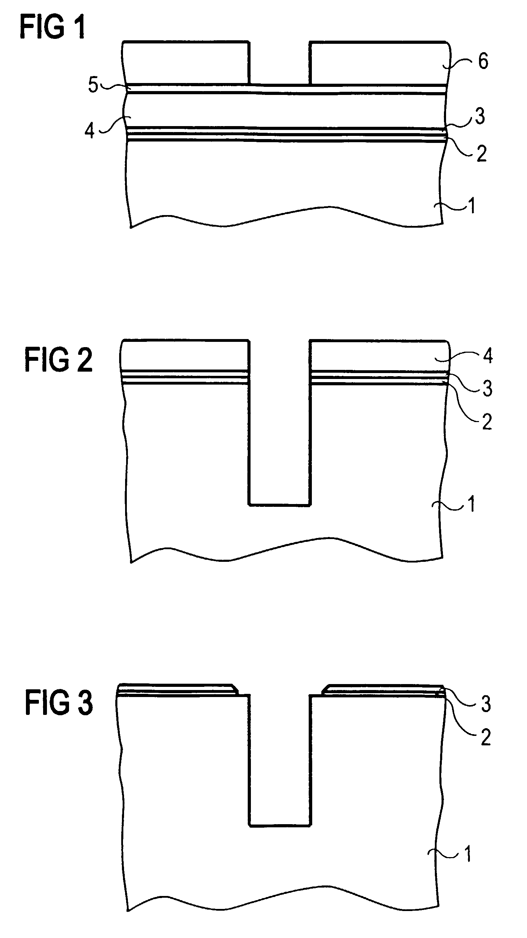

Figur 1 bis 4 einen Querschnitt durch ein Halbleitersubstrat, an dem die Verfahrensschritte des Ausführungsbeispiels dargestellt werden.

Figur 1: auf einem aus Silizium bestehenden Halbleitersubstrat 1 wird eine thermische Siliziumoxidschicht 2 von etwa 8 nm Schichtdicke erzeugt. Darauf wird eine Siliziumnitridschicht 3 von etwa 200 bis 250 nm Schichtdicke abgeschieden. Diese Zwischenschicht 2, 3 (hier eine Doppelschicht) wird in späteren Verfahrensschritten, die für den eigentlichen Ätzprozeß nicht relevant sind, beispielsweise als Schutzschicht benötigt. Auf die Nitridschicht 3 wird eine aus dotiertem Siliziumoxid bestehende Hartmaskenschicht 4 in einer Dicke von etwa 700 nm aufgebracht. Es wird SACVD-Prozeß in einer Vakuumkammer (beispielsweise AMAT P5000-Anlage) eingesetzt, wobei die Parameter so eingestellt werden, daß die Glasschicht eine Dotierung von 3,5 bis 4,5 Gew.% Bor aufweist. Nach Beenden des Abscheideprozesses werden die Vakuum-bedingungen für den Wafer aufrecht erhalten, d.h. der Wafer wird ohne Unterbrechung der Vakuumbedingungen in eine zweite Kammer (PECVD-Kammer) bewegt. Es wird ein Inertplasma zur Verdichtung der Glasschicht gezündet, bei dem in die Prozeßkammer beispielsweise Helium und N₂O eingeleitet werden. Dazu kann ein N₂O-Fluß von bis zu 1000 sccm und ein Helium-Fluß von bis zu 8000 sccm eingestellt werden, sowie ein Prozeßdruck im Bereich 1-10 Torr und eine Leistung im Bereich 50-500 Watt. Die Dauer dieses Inertplasmaschritts kann etwa eine Minute betragen. Bei relativ niedriger Dotierung der Glasschicht kann auf den Inertplasmaschritt auch verzichtet werden. Anschließend wird ohne Unterbrechung der Vakuumbedingungen, vorzugsweise in derselben Prozeßkamer, eine dielektrische Antireflexschicht 5, insbesondere ein Oxinitrid, auf die dotierte Glasschicht 4 mittels eines plasmagestützten Abscheideprozesses aufgebracht. Die Dicke dieser Antireflexschicht ist von den optischen Eigenschaften abhängig und liegt vorzugsweise im Bereich 40-200 nm. Vorzugsweise werden folgende Prozeßparameter eingestellt:
Silan-Fluß 40-100 sccm, N₂O-Fluß 90-150 sccm, Inertgas-Fluß (He, Ar, N₂), 1000-5000 sccm, Prozeßdruck 5-7 Torr, HF-Leistung 70-170 W.
Damit sind Abscheideraten für die dielektrische Antireflexschicht von 200-400 nm/Minute erreichbar. Auf die soweit fertiggestellte Anordnung wird dann eine Lackmaske 6 aufgebracht, die der herzustellenden Hartmaske entspricht.

Figur 2: Mit der Lackmaske 6 werden zunächst die Antireflexschicht 5 und die dotierte Glasschicht 4 sowie die Zwischenschicht 3, 2 strukturiert. Die Lackmaske wird entfernt. Die dotierte Glasschicht 4 mit der darüberliegenden Antireflexschicht 5 dient nun als Hartmaske für die Ätzung des Siliziumsubstrates 1. Bei der Grabenätzung in das Substrat 1 wird die Antireflexschicht 5 vollständig abgetragen.

Figur 3: Nach der Grabenätzung sollen die verbliebenen Reste der Hartmaske 4 möglichst schnell und ausreichend selektiv zu der Zwischenschicht naßchemisch entfernt werden. Weiterhin muß im oberen Bereich des Grabens die Nitridschicht 3 um ca. 10 bis 14 nm seitlich zurückgeätzt werden. Eventuell vorhandene oxidische Ablagerungen aus der Grabenätzung müssen ebenfalls entfernt werden. Dazu wird eine HF-EG-Mischung in Verhältnis 4:96 eingesetzt, die auf etwa 80°C erwärmt wird. Der Ätzprozeß kann in einer Semitol-Anlage durchgeführt werden.

Dabei werden die Wafer in einer Charge zu 25 bis 50 Wafern in eine rotierbare Halterung gesetzt und mit N₂ und Glycol konditioniert. Anschließend werden sie gleichmäßig mit der temperierten Ätzmischung besprüht. Nachfolgend wird diese Ätzmischung in eine Reihe von Spülschritten wieder vollständig entfernt und die Wafer abschließend getrocknet. Bei diesem Prozeß beträgt die Ätzrate des dotierten Glases etwa 220 (+-30) nm/Minute, die Ätzrate des Nitrides 4,0 (+/-0,4) und die Ätzrate des thermischen Oxides 3,0 (+/- 0,3) nm/Minute. Die Selektivität der Hartmaskenschicht zu thermischen Oxid beträgt demnach etwa 75. Es liegt also eine hochselektive Ätzung des dotierten Glases zu thermischen Oxid und zu Nitrid vor, während gleichzeitig thermisches Oxid und Nitrid etwa gleichschnell geätzt werden. Es wurde festgestellt, daß die Selektivität der Naßätzrate maßgeblich über die Abscheidebedingungen der dotierten Glasschicht und der Antireflexschicht beeinflußt werden. Dagegen werden die Ätzratenverhältnisse der drei beteiligten Schichten 2, 3 und 4 nur wenig von der Prozeßtemperatur und von dem HF-Anteil in der Ätzmischung innerhalb der weiter vorne angegebenen Grenzen beeinflußt.

Gleichzeitig mit der Ätzung der dotierten Glasschicht 4 und der Entfernung der oxidischen Ablagerungen aus der Grabenätzung wird die Zwischenschicht 2, 3 an der offenen Grabenwand zurückgeätzt, und zwar um einen Betrag von etwa 8 bis 15 nm. Die Ätzzeit beträgt etwa 200 Sekunden. In dieser Zeit ist auch die Hartmaske 4 vollständig entfernt, da bei der Grabenätzung im allgemeinen die Hartmaskenschicht schon etwas gedünnt wird.

## Patentansprüche

1. Herstellverfahren für eine Halbleiterstruktur mit folgenden Schritten:
- Abscheiden einer dotierten Siliziumoxidschicht (4) auf einem Träger (1) in einem ersten CVD-Schritt und Abscheiden einer Antireflexschicht (5) auf der Siliziumoxidschicht (4) in einem plasmagestützten zweiten CVD-Schritt ohne Unterbrechung der Vakuumbedingungen für den Träger zwischen dem ersten und dem zweiten CVD-Schritt,
- Strukturieren der dotierten Siliziumoxidschicht (4) und der Antireflexschicht (5) zu einer Maske,
- Ätzen des Trägers unter Verwendung der Maske,
- Entfernen der Antireflexschicht (5),
- Entfernen der Siliziumoxidschicht (4) mit einer Ätzlösung, die HF und Ethylenglycol und/oder Schwefelsäure enthält.

2. Verfahren nach Anspruch 1, bei dem eine Zwischenschicht (2, 3) auf den Träger (1) vor dem Abscheiden der dotierten Siliziumoxidschicht aufgebracht wird,
bei dem die Zwischenschicht unter Verwendung der Maske geätzt wird,
bei dem eine Ätzlösung mit HF und Ethylenglycol verwendet wird,
bei dem gleichzeitig mit der Entfernung der dotierten Siliziumschicht (4) die Zwischenschicht (2, 3) geätzt wird, so daß die Kante der Zwischenschicht zurückversetzt wird

3. Verfahren nach Anspruch 1 oder 2, bei dem als Zwischenschicht eine thermische Siliziumoxidschicht (2) und/oder eine Siliziumnitridschicht (3) verwendet wird.

4. Herstellverfahren nach einem der Ansprüche 1 bis 3,bei dem als Antireflexschicht eine dielektrische Antireflexschicht (5), insbesndere eine Siliziumoxinitrid-Schicht, verwendet wird.

5. Herstellverfahren nach einem der Ansprüche 2 bis 4, bei dem ein HF/Ethylenglycol-Gemisch verwendet wird, das 2-10 Vol.% HF und 98-90 Volumenprozent Ethylenglycol enthält.

6. Verfahren nach einem der Ansprüche 2 bis 5, bei dem die Ätzung mit dem HF/Ethylenglycol-Gemisch bei 70-90 °C durchgeführt wird.

7. Verfahren nach einem der Ansprüche 1 bis 6, bei dem zwischen der Abscheidung der dotierten Siliziumoxidschicht (4) und der dielektrischen Antireflexschicht (5) ein Inertplasmaschritt zur Verfestigung der dotierten Siliziumoxidschicht ohne Unterbrechung des Vakuums durchgeführt wird.
